# EUROPÄISCHE PATENTSCHRIFT

(11) **EP 0 679 024 B1**
(45) Veröffentlichungstag und Bekanntmachung des Hinweises auf die Patenterteilung: **01.03.2000**
(21) Anmeldenummer: 95200961.1
(22) Anmeldetag: 18.04.1995
(51) Int. Cl.: H04N 5/775, H04N 5/44

(54) **Schaltungsanordnung mit einer Hochfrequenz-Empfangsstufe und einem Modulator zur Übertragung**
Circuit with a high frequency receiver stage and a modulator for transmission
Circuit avec un étage de réception haute fréquence et un modulateur pour transmission

(30) Priorität: 21.04.1994 DE 4413927
(43) Veröffentlichungstag der Anmeldung: 25.10.1995
(73) Patentinhaber: Philips Corporate Intellectual Property GmbH, 52064 Aachen (DE); Koninklijke Philips Electronics N.V., 5621 BA Eindhoven (NL)
(72) Erfinder: Ruitenburg, Leo, D-20097 Hamburg (DE)
(74) Vertreter: Peters, Carl Heinrich, Dipl.-Ing.

(56) Entgegenhaltungen:
- GB-A- 1 524 183
- IEEE TRANSACTIONS ON CONSUMER ELECTRONICS, Bd. 38, Nr. 3, 1.August 1992, Seiten 389-392, XP000311869 MAIER G M ET AL: "NEW HIGH DENSITY MULTISTANDARD RF-CONCEPT FOR VCR"

## Beschreibung

Die Erfindung bezieht sich auf eine Schaltungsanordnung mit einer Hochfrequenz-Empfangsstufe (Tuner) und einer eine Signalaufteilschaltung (Splitter) und eine Modulationsanordnung (Modulator) umfassenden Übertragungsstufe (Splitter-Modulator).

Konventionelle Tuner und Splitter-Modulatoren benötigen je einen Kristalloszillator als Frequenzreferenz. Eine Schaltungsanordnung, die sowohl einen Tuner als auch einen Splitter-Modulator enthält, wie dies vorzugsweise bei Hochfrequenz-Verarbeitungsstufen in Videorecordern der Fall ist, muß daher zwei Schwingquarze enthalten, was mit hohem Aufwand verbunden ist.

Aus der Zeitschrift IEEE TRANSACTIONS ON CONSUMER ELECTRONICS, Bd. 38, Nr. 3, 1. August 1992, Seiten 389-392, XP00031869 MAIER G ET AL: "NEW HIGH DENSITY MULTISTANDARD RF-CONCEPT FOR VCR" ist ein kompaktes Multistandard-Hochfrequenz-Konzept für Videorecorder bekannt, welches einen Leistungsteiler, einen Antennenschalter, einen Modulator und einen Tuner umfaßt. In diesem Schaltungskonzept werden der Tuner und der Modulator durch eine phasenverriegelte Schleife gesteuert, wobei die Modulatorfrequenz zum hochfrequenten Ende des UHF-Bandes hin verlegt ist. Durch diese Anordnung sollen alle weltweit existierenden Frequenzbänder für Videosignalübertragung und selbst die positive sowie die negative Modulation für die Normen SECAM, PAL und NTSC abgedeckt werden können.

Die Erfindung hat die Aufgabe, den Schaltungsaufwand für eine Schaltungsanordnung zu reduzieren, die sowohl einen Tuner als auch einen Splitter-Modulator umfaßt.

Erfindungsgemäß wird diese Aufgabe gelöst durch eine Schaltungsanordnung mit einer Hochfrequenz-Empfangsstufe und einer eine Signalaufteilschaltung und eine Modulationsanordnung umfassenden Übertragungsstufe, wobei die Signalaufteilschaltung einen Hochfrequenzsignaleingang zum Zuführen eines Hochfrequenzeingangssignals, einen Hochfrequenzsignalausgang zum Abgeben eines Hochfrequenzausgangssignals, eine erste Leitung zum Abgeben des Hochfrequenzeingangssignals an die Empfaugsstufe und eine zweite Leitung zum Zuführen eines Hochfrequenzausgangssignals von der Modulationsanordnung aufweist und wobei die Empfangsstufe zum Demodulieren des Hochfrequenzeingangssignals und die Modulationsanordnung zum Umsetzen eines Basisbandsignals in das von ihr abzugebende Hochfrequenzausgangssignal eingerichtet ist, mit Einrichtungen zum Erzeugen von Referenzschwingungen für die Hochfrequenz-empfangsstufe und die Übertragungsstufe, wobei diese Einrichtungen wenigstens einen für die Hochfrequenz-Empfangsstufe und die Übertragungsstufe gemeinsamen Schwingquarz aufweisen.

Um den Aufwand zu reduzieren, sieht die Erfindung somit vor, die Frequenzreferenz sowohl für den Tuner als auch für den Splitter-Modulator aus einem einzigen Schwingquarz bzw. Kristalloszilator abzuleiten. Damit kann ein Kristalloszillator eingespart werden. Der einzige Kristalloszillator kann dann je einen Schwingungsgenerator (Synthesizer) im Tuner und im Splitter-Modulator speisen. Insbesondere wird dabei der Schwingquarz bzw. Kristalloszillators des Tuners vom Splitter-Modulator mit benutzt. Vorzugsweise kann dann im Splitter-Modulator anstelle des gesonderten Kristalloszillators eine Transistorkoppelstufe zwischen dem Schwingquarz des Tuners und dem Schwingungsgenerator, beispielsweise einer phasenverriegelten Schleife, des Splitter-Modulators eingefügt sein. Durch diese Transistorkoppelstufe kann eine Verstärkung der Referenzschwingungen sowie deren niederohmige Einkopplung in den Schwingungsgenerator des Splitter-Modulators vorgenommen werden.

Bei der Erfindung weisen die Einrichtungen zum Erzeugen von Referenzschwingungen eine für die Hochfrequenz-Empfangsstufe (Tuner) und die Übertragungsstufe (Splitter-Modulator) gemeinsame phasenverriegelte Schleife auf. Bei dieser Ausgestaltung wird der Aufwand dadurch weiter reduziert, daß für die zu einer Baugruppe zusammengefaßte Kombination aus Tuner und Splitter-Modulator nur noch ein einziger, gemeinsamer Schwingungsgenerator zum Einsatz kommt. Dafür wird dann nur ein Schwingquarz, nur eine phasenverriegelte Schleife und nur eine Oszillatorstufe benötigt.

Eine Schaltung gemäß dem Stand der Technik und ein der Erfindung Ausführungsbeispiel, in denen übereinstimmende Elemente mit denselben Bezugszeichen versehen sind, sind in der Zeichnung dargestellt. Es zeigen:
**Fig. 1** ein Beispiel einer Kombination aus Tuner und Splitter-Modulator mit einem gemeinsamen Schwingquarz und
**Fig. 2** eine derartige Kombination mit einem gemeinsamen Schwingquarz und einem gemeinsamen Schwingungsgenerator.

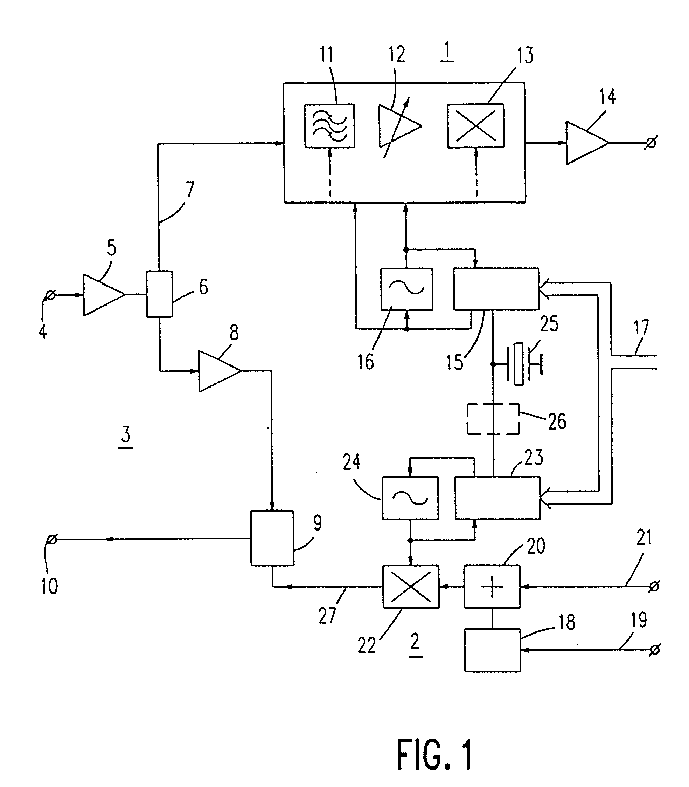

Fig. 1 zeigt eine Kombination aus einem Tuner 1, einem Modulator 2 und einem Splitter 3, wobei Modulator 2 und Splitter 3 zusammengefaßt eine Übertragungsstufe (Splitter-Modulator) darstellen. Über einen Hochfrequenzsignaleingang 4 ist dem Splitter 3 ein Hochfrequenzeingangssignal, beispielsweise ein Fernsehsignal von einer Antenne, zuführbar. Es gelangt über einen ersten Vorverstärker 5 auf eine erste Signalweiche 6 und von dieser einerseits an eine erste Leitung 7 und andererseits über einen zweiten Vorverstärker 8 an eine zweite Signalweiche 9. Von dieser kann es über einen Hochfrequenzsignalausgang 10 abgegeben werden.

Von der ersten Leitung 7 gelangt das Hochfrequenzeingangssignal an den Tuner 1, in dem in üblicher Weise eine Frequenzselektion 11, eine Amplitudenregelung 12 und eine Abwärtsmischung 13 durch dafür gebräuchliche Stufen vorgenommen wird. Über einen Ausgangsverstärker 14 wird ein Zwischenfrequenzsignal abgegeben. Den Stufen 11 für die Frequenzselektion und 13 für die Abwärtsmischung werden in an sich üblicher Weise Referenzschwingungen von einem dem Tuner 1 zugeordneten Schwingungsgenerator zugeleitet, der eine phasenverriegelte Schleife 15 und eine Oszillatorstufe 16 umfaßt. Die phasenverriegelte Schleife 15 ist zur Abstimmung des Tuners 1 über Steuerleitungen 17, vorzugsweise einen I2C-Bus, ansteuerbar.

Der Modulator 2 enthält in an sich bekannter Weise einen Audiosignal-Modulator 18, dem an einem Audiosignaleingang 19 ein Audio-Basisbandsignal zuleitbar ist und der dieses auf eine Tonträgerschwingung aufmoduliert. Das modulierte Audiosignal wird in einer Überlagerungsstufe 20 einem über einen Videosignaleingang 21 zugeführten Video-Basisbandsignal überlagert. Das so erhaltene, kombinierte Basisbandsignal wird in einer Basisbandsignal-Modulatorstufe 22 auf eine Hochfrequenz-Trägerschwingung aufmoduliert, die in einem Schwingungsgenerator des Modulators 2 erzeugt wird, der eine zweite phasenverriegelte Schleife 23 und eine zweite Oszillatorstufe 24 umfaßt. Der Schwingungsgenerator 23, 24 des Modulators 2 weist im Prinzip denselben Aufbau wie derjenige des Tuners 1. Insbesondere werden beide Schwingungsgeneratoren 15, 16 und 23, 24 aus einem einzigen Schwingquarz gesteuert, wobei zwischen dem Schwingquarz 25 und der zweiten phasenverriegelten Schleife 23 eine Transistorkoppelstufe 26 zur Schwingungsverstärkung und niederohmigen Einkopplung angeordnet sein kann.

Von der Basisbandsignal-Modulatorstufe 22 führt eine zweite Leitung 27 das Hochfrequenzausgangssignal des Modulators 2 der zweiten Signalweiche 9 des Splitters 3 zu, über die es an den Hochfrequenzsignalausgang 10 gelangt.

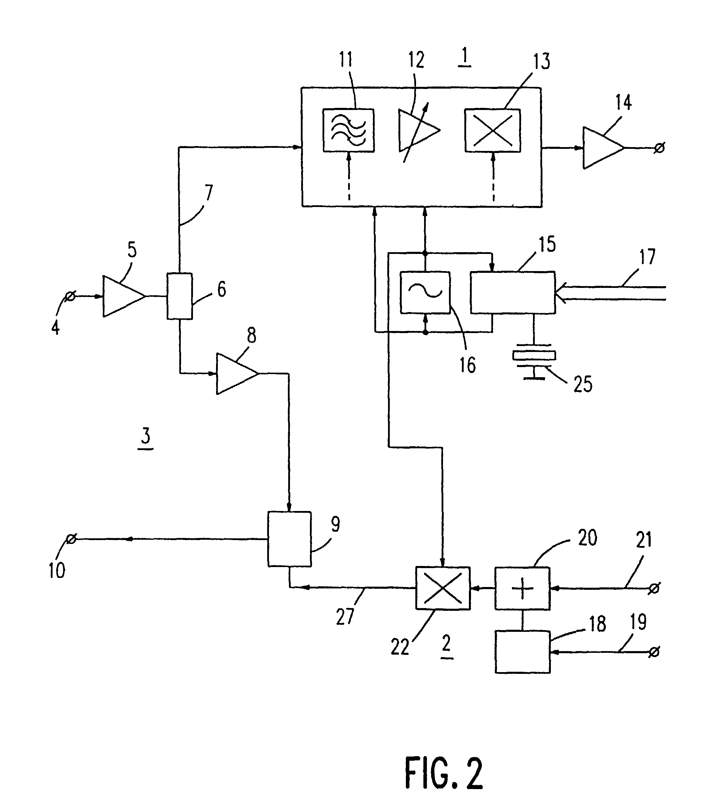

Im Ausführungsbeispiel nach Fig. 2, welches ansonsten mit dem Beispiel nach Fig. 1 übereinstimmt, sind erfindungsgemäß die zweite phasenverriegelte Schleife 23 und die zweite Oszillatorstufe 24, d.h. der gesonderte Schwingungsgenerator des Modulators 2, weggelassen. Die Basisbandsignal-Modulatorstufe 22 des Modulators 2 wird unmittelbar aus der Oszillatorstufe 16 des Schwingungsgenerators des Tuners 1 gespeist.

Eine bevorzugte Anwendung dieser Schaltungsanordnungen liegt bei Hochfrequenz-Verarbeitungsstufen von Videorecordern.

## Patentansprüche

1. Schaltungsanordnung mit einer Hochfrequenz-Empfangsstufe (1) und einer eine Signalaufteilschaltung (3) und eine Modulationsanordnung (2) umfassenden Übertragungsstufe, wobei die Signalaufteilschaltung (3) einen Hochfrequenzsignaleingang (4) zum Zuführen eines Hochfrequenzeingangssignals (10), einen Hochfrequenzsignalausgang zum Abgeben eines Hochfrequenzausgangssignals, eine erste Leitung (7) zum Abgeben des Hochfrequenzeingangssignals an die Empfangsstufe (1) und eine zweite Leitung (27) zum Zuführen eines Hochfrequenzausgangssignals von der Modulationsanordnung (2) aufweist und wobei die Empfangsstufe (1) zum Demodulieren des Hochfrequenzeingangssignals und die Modulationsanordnung (2) zum Umsetzen eines Basisbandsignals in das von ihr abzugebende Hochfrequenzausgangssignal eingerichtet ist, mit Einrichtungen zum Erzeugen von Referenzschwingungen für die Hochfrequenzempfangsstufe (1) und die Übertragungsstufe (2, 3), wobei diese Einrichtungen wenigstens einen für die Hochfrequenz-Empfangsstufe (1) und die Übertragungsstufe (2,3) gemeinsamen Schwingquarz (25) aufweisen, dadurch gekennzeichnet,
daß die Einrichtungen zum Erzeugen von Referenzschwingungen eine für die Hochfrequenz-Empfangsstufe (1) und die Übertragungsstufe (2, 3) gemeinsame phasenverriegelte Schleife (15) aufweisen.

## Claims

1. A circuit arrangement comprising a tuner (1) and a splitter-modulator comprising a splitter (3) and a modulator (2), the splitter (3) having an RF signal input (4) for applying an RF input signal (10), an RF signal output for supplying an RF output signal, a first line (7) for applying the RF input signal to the tuner (1) and a second line (27) for supplying an RF output signal from the modulator (2), the tuner (1) being adapted to demodulate the RF input signal, and the modulator (2) being adapted to convert a baseband signal into the RF output signal to be supplied by said modulator, and comprising devices for generating reference oscillations for the tuner (1) and the splitter-modulator (2,3), said devices having at least one quartz crystal (25) which is common for the tuner (1) and the splitter-modulator (2,3), characterized in that the devices for generating reference oscillations comprise a phase-locked loop (15) which is common for the tuner (1) and the splitter-modulator (2,3).

## Revendications

1. Circuit avec un étage de réception haute fréquence (1) et un étage de transmission comprenant un circuit de répartition des signaux (3) et un dispositif de modulation (2), le circuit de répartition des signaux (3) comprenant une entrée de signal haute fréquence (4) en vue d'amener un signal d'entrée haute fréquence (10), une sortie de signal haute fréquence en vue de délivrer un signal de sortie haute fréquence, une première ligne (7) en vue de délivrer le signal d'entrée haute fréquence à l'étage de réception (1) et une deuxième ligne (27) en vue d'amener un signal de sortie haute fréquence du dispositif de modulation (2) et l'étage de réception (1) étant aménagé en vue de la démodulation du signal d'entrée haute fréquence et le dispositif de modulation (2) en vue de la transformation d'un signal en bande de base dans le signal de sortie haute fréquence délivré par celui-ci, avec des dispositifs de production d'oscillations de référence pour l'étage de réception haute fréquence (1) et l'étage de transmission (2,3), ces dispositifs présentant au moins un quartz oscillateur (25) commun pour l'étage de réception haute fréquence (1) et l'étage de transmission (2, 3), caractérisé en ce
que les dispositifs de production d'oscillations de référence présentent une boucle (15) à verrouillage de phase commune pour l'étage de réception haute fréquence (1) et l'étage de transmission (2,3).
